# EUROPEAN PATENT APPLICATION

(11) **EP 3 188 365 A1**
(43) Date of publication of application: **05.07.2017**
(21) Application number: 15835817.6
(22) Date of filing: 24.03.2015
(51) Int. Cl.: H03G 3/20

(54) **AUTOMATIC VOLUME ADJUSTING METHOD AND ELECTRONIC DEVICE THEREOF**

(30) Priority: 29.08.2014 CN 201410438430
(71) Applicant: ZTE Corporation, Shenzhen, Guangdong 518057 (CN)
(72) Inventor: XU, Weichang, Shenzhen Guangdong 518057 (CN)
(74) Representative: Novagraaf Technologies
(86) International application number: PCT/CN2015/074964
(87) International publication number: WO 2016/029688

(57) **Abstract**

Provided is an automatic volume tuning method. The method includes the following steps. Audio data of a program source is decoded into Pulse Code Modulation (PCM) data. The PCM data within a preset period is statistically analyzed to obtain an audio characteristic value. The audio characteristic value is compared with a preset audio amplitude reference value, and the PCM data is processed according to a comparison result to tune an output volume. Also provided is an automatic volume tuning electronic device. The technical solution keeps an actual output volume within a normal and stable range, and avoids fluctuation of the output volume.

## Description

### Technical Field

The present disclosure relates to the technical field of volume tuning, and in particular to an automatic volume tuning method and electronic device.

### Background

At present, when programs from different program sources are played on an electronic device, the volume may suddenly fluctuate when a user switches different programs since original volumes of all program sources are different. This problem influences the program watching comfort of the user, and it is troublesome for the user to frequently and manually operate a remote controller to tune the volume. In particular, as an Internet Protocol Television (IPTV) and a network technology are developing rapidly, for example, as an electronic device such as a network set-top box is widely applied to the field of household multimedia entertainment, program contents watched via the network set-top box are richer and richer. When the user frequently switches among massive television programs, fluctuation of an output volume and manual volume tuning bring great inconvenience to the user.

### Summary

Embodiments of the present disclosure are mainly intended to solve the technical problem of fluctuation of an output volume during playing of programs from different program sources.

In order to solve the above technical problem, the following technical solution is adopted.

An automatic volume tuning method is provided, which includes the following steps.

Audio data of a program source is decoded into Pulse Code Modulation (PCM) data.

The PCM data within a preset period is statistically analyzed to obtain an audio characteristic value.

The audio characteristic value is compared with a preset audio amplitude reference value, and the PCM data is processed according to a comparison result to tune an output volume.

In an exemplary embodiment, the audio characteristic value may be an average audio amplitude value of the PCM data within the preset period.

In an exemplary embodiment, the step that the audio characteristic value is compared with the preset audio amplitude reference value and the PCM data is processed according to the comparison result to tune the output volume may include the following processing.

When the average audio amplitude value is greater than the preset audio amplitude reference value and an absolute value of difference between the average audio amplitude value and the audio amplitude reference value is greater than a set threshold value, the PCM data is attenuated until the absolute value of the difference between the average audio amplitude value and the audio amplitude reference value is decreased below the set threshold value.

When the average audio amplitude value is smaller than the preset audio amplitude reference value and an absolute value of difference between the average audio amplitude value and the audio amplitude reference value is greater than a set threshold value, the PCM data is enhanced until the absolute value of the difference between the average audio amplitude value and the audio amplitude reference value is decreased below the set threshold value.

In an exemplary embodiment, before the step that the audio characteristic value is compared with the preset audio amplitude reference value and the PCM data is processed according to the comparison result to tune the output volume, the method may further include the following processing.

Current time is obtained, and an audio amplitude reference value of the current time is set according to a mapping relationship, preset by a user, between different time periods and audio amplitude reference values, as well as a time period corresponding to the current time.

In an exemplary embodiment, after the step that the audio amplitude reference value of the current time is set according to the mapping relationship, preset by the user, between different time periods and audio amplitude reference values as well as the time period corresponding to the current time, the method may further include the following processing.

When a current time period switches to a different time period in a program playing process, the audio amplitude reference value of the current time is updated in real time according to the mapping relationship, preset by the user, between different time periods and the audio amplitude reference values as well as the time period corresponding to the current time.

In an exemplary embodiment, before the step that audio data of the program source is decoded into the PCM data, the method may further include the following processing.

An instruction indicating that a user selects to automatically tune the volume is received, and an automatic volume tuning function is started.

An automatic volume tuning electronic device is provided, which includes a decoding module, an analysis module and a comparison and tuning module.

The decoding module is arranged to decode audio data of a program source into PCM data.

The analysis module is arranged to statistically analyze the PCM data within a preset period to obtain an audio characteristic value.

The comparison and tuning module is arranged to compare the audio characteristic value with a preset audio amplitude reference value, and process the PCM data according to a comparison result to tune an output volume.

In an exemplary embodiment, the audio characteristic value may be an average audio amplitude value of the PCM data within the preset period.

In an exemplary embodiment, the comparison and tuning module may be arranged to compare the audio characteristic value with a preset audio amplitude reference value and process the PCM data according to a comparison result to tune the output volume according to the following mode.

When the average audio amplitude value is greater than the preset audio amplitude reference value and an absolute value of difference between the average audio amplitude value and the audio amplitude reference value is greater than a set threshold value, attenuating the PCM data until the absolute value of the difference between the average audio amplitude value and the audio amplitude reference value is decreased below the set threshold value.

When the average audio amplitude value is smaller than the preset audio amplitude reference value and an absolute value of difference between the average audio amplitude value and the audio amplitude reference value is greater than a set threshold value, enhancing the PCM data until the absolute value of the difference between the average audio amplitude value and the audio amplitude reference value is decreased below the set threshold value.

In an exemplary embodiment, the electronic device may further include a setting module.

The setting module is arranged to obtain current time, and set an audio amplitude reference value of the current time according to a mapping relationship, preset by a user, between different time periods and audio amplitude reference values, as well as a time period corresponding to the current time.

In an exemplary embodiment, the setting module may be further arranged to:
update, when a current time period switches to a different time period in a program playing process, the audio amplitude reference value of the current time in real time according to the mapping relationship, preset by the user, between different time periods and the audio amplitude reference values as well as the time period corresponding to the current time.

In an exemplary embodiment, the electronic device may further include a starting module.

The starting module is arranged to receive an instruction indicating that a user selects to automatically tune the volume, and start an automatic volume tuning function.

A computer program is provided, which may include program instructions. When the program instructions are executed by a computer, the computer is caused to execute any of the above-mentioned automatic volume tuning methods.

A carrier carrying the computer program is also provided.

According to the automatic volume tuning method and electronic device in the technical solution provided by the embodiments of the present disclosure, audio data of a program source is decoded into PCM data, and an audio characteristic value capable of reflecting audio characteristics of the audio data is obtained; and the audio characteristic value is compared with a preset normal audio amplitude reference value, and the PCM data is processed according to a comparison result to tune an output volume within a normal range. In this way, original volumes of different program sources can be tuned correspondingly to keep an actual output volume within a normal and stable range and avoid fluctuation of the output volume.

### Brief Description of the Drawings

Fig. 1 is a flowchart of an automatic volume tuning method according to a first embodiment of the present disclosure;
Fig. 2 is a flowchart of an automatic volume tuning method according to a second embodiment of the present disclosure;
Fig. 3 is a flowchart of an automatic volume tuning method according to a third embodiment of the present disclosure;
Fig. 4 is a functional module diagram of an automatic volume tuning electronic device according to a first embodiment of the present disclosure;
Fig. 5 is a functional module diagram of an automatic volume tuning electronic device according to a second embodiment of the present disclosure; and
Fig. 6 is a functional module diagram of an automatic volume tuning electronic device according to a third embodiment of the present disclosure.

The purpose fulfillment, functional features and advantages of the present disclosure will be further illustrated with the embodiments and the drawings.

### Detailed Description of the Embodiments

It should be understood that the specific embodiments described here are only intended to explain the present disclosure, and are not thus limitative of the present disclosure.

Some embodiments of the present disclosure provide an automatic volume tuning method.

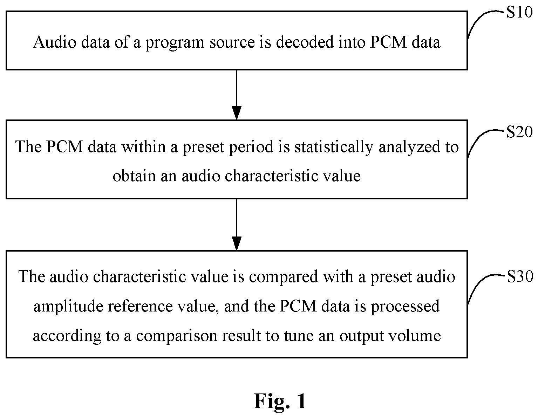

Fig. 1 is a flowchart of an automatic volume tuning method according to a first embodiment of the present disclosure.

As shown in Fig. 1, in the first embodiment, the automatic volume tuning method includes the following steps S10 to S30.

At step S10, audio data of a program source is decoded into PCM data.

In the present embodiment, the program source may be an audio/video program, or may be a pure audio program or other multimedia programs including audio data, which will not be limited here. After the program source is received, the audio data of the program source is decoded to obtain PCM data.

At step S20, the PCM data within a preset period is statistically analyzed to obtain an audio characteristic value.

The decoded PCM data is processed. Specifically, the PCM data within the preset period namely a certain time window is statistically analyzed to obtain an audio characteristic value capable of reflecting audio characteristics of the audio data of the program source. The audio characteristic value capable of reflecting the audio characteristic of the PCM data within the certain time window may include parameters such as a maximum amplitude, a minimum amplitude and an average audio amplitude value. The audio characteristic value may be obtained accurately by mathematical operation and combination of various parameters. In the present embodiment, the audio characteristic value is an average audio amplitude value of the PCM data with a preset period preferably, so as to avoid influence from over high amplitude and over low amplitude suddenly caused by interference within the preset period, enabling the audio characteristic value to reflect the overall audio characteristics of the audio data of the program source. Certainly, the audio characteristic value is not limited as other parameter values.

At step S30, the audio characteristic value is compared with a preset audio amplitude reference value, and the PCM data is processed according to a comparison result to tune an output volume.

In the present embodiment, a user may preset a common audio amplitude parameter value according to his/her own demands. When an audio is at the common audio amplitude parameter value, the output volume is optimal. The audio characteristic value namely an average audio amplitude value of the PCM data within the preset period is compared with a preset audio amplitude reference value. When the average audio amplitude value is greater than the preset audio amplitude reference value, the PCM data is attenuated until the average audio amplitude value is equal to the preset audio amplitude reference value. When the average audio amplitude value is smaller than the preset audio amplitude reference value, the PCM data is enhanced until the average audio amplitude value is equal to the preset audio amplitude reference value. In this way, the average audio amplitude value of the output PCM data is tuned to be equal to the preset audio amplitude reference value. No matter whether original volumes of different program sources are the same, it can be ensured that the finally-output volume is optimal, thereby avoiding the situation of fluctuation of the output volume.

Further, in another implementation mode, the user may preset a common audio amplitude reference value and threshold values according to actual situations. The output volume is neither over-high nor over-low when the audio is within a range of upper and lower threshold values of the common audio amplitude reference value, so the user can watch a program comfortably. Moreover, the output volume is limited within a small fluctuation range, and the actual operation is simple and quick.

The audio characteristic value capable of reflecting the audio characteristics of the audio data of the program source, namely an average audio amplitude value of the PCM data within the preset period, is compared with a preset audio amplitude reference value. When the average audio amplitude value is greater than the preset audio amplitude reference value and an absolute value of difference between the average audio amplitude value and the audio amplitude reference value is greater than a set threshold value, it represents that the average audio amplitude value excessively deviates from the audio amplitude reference value, the PCM data is entirely attenuated until the absolute value of the difference between the average audio amplitude value and the audio amplitude reference value is decreased below the set threshold value, thereby ensuring that the average audio amplitude value falls within a normal fluctuation range of the audio amplitude reference value. When the average audio amplitude value is smaller than the preset audio amplitude reference value and an absolute value of difference between the average audio amplitude value and the audio amplitude reference value is greater than a set threshold value, it represents that the average audio amplitude value excessively deviates from the audio amplitude reference value, the PCM data is entirely enhanced until the absolute value of the difference between the average audio amplitude value and the audio amplitude reference value is decreased below the set threshold value. Thus, by attenuating or enhancing the PCM data, the average audio amplitude value of the output PCM data is within the upper and lower threshold value range of the preset audio amplitude reference value. No matter whether the original volumes of different program sources are the same, it can be ensured that the finally-output volume is within a smaller fluctuation range, so the user can watch a program comfortably, thereby avoiding the situation of fluctuation of the output volume.

According to the present embodiment, audio data of a program source is decoded into PCM data, and an audio characteristic value capable of reflecting audio characteristics of the audio data is obtained; and the audio characteristic value is compared with a preset normal audio amplitude reference value, and the PCM data is processed according to a comparison result to tune an output volume within a normal range. In this way, original volumes of different program sources can be tuned correspondingly to keep an actual output volume within a normal and stable range and avoid fluctuation of the output volume. The program watching comfort of the user is improved, the user does not need to manually operate a remote controller, the volume can be automatically tuned, and intelligence is improved.

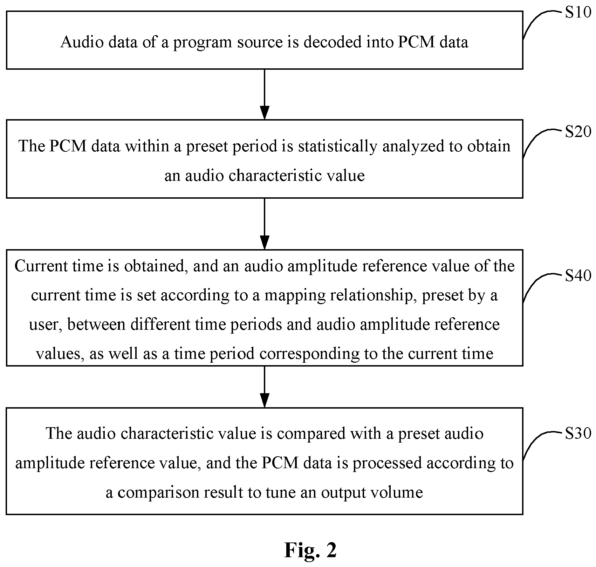

Fig. 2 is a flowchart of an automatic volume tuning method according to a second embodiment of the present disclosure.

As shown in Fig. 2, in the second embodiment, before step S30, the method further includes the following step S40.

At step S40, current time is obtained, and an audio amplitude reference value of the current time is set according to a mapping relationship, preset by a user, between different time periods and audio amplitude reference values, as well as a time period corresponding to the current time.

In the present embodiment, the user may preset a mapping relationship between different time periods and corresponding audio amplitude reference values according to own requirements. That is, the user may set different audio amplitude reference values corresponding to different time periods. For example, the user may set time periods from 13:00 to 14:00 and from 22:00 to 8:00 as rest periods, and a specific audio amplitude reference value which is relatively low is correspondingly set for this specific time period. Normal audio amplitude reference values are correspondingly set for other time periods, and the normal audio amplitude reference values may be relatively high.

Before the audio characteristic value is compared with the preset audio amplitude reference value and the PCM data is processed according to the comparison result, current time is obtained, and an audio amplitude reference value of the current time is set according to a time period corresponding to the current time and the mapping relationship, preset by the user, between different time periods and corresponding audio amplitude reference values. For example, in the present embodiment, if the current time is within time periods from 13:00 to 14:00 and from 22:00 to 8:00, the audio amplitude reference value of the current time is set as a specific audio amplitude reference value. If the current time is within other time periods, the audio amplitude reference value of the current time is set as a normal audio amplitude reference value. Thus, when the audio characteristic value is compared with the set audio amplitude reference value subsequently, different standard audio amplitude reference values can be set according to different time periods of the current time. A lower audio amplitude reference value is set within a rest period, so the finally-output actual volume is at a lower level, thereby avoiding disturbing the user. A normal audio amplitude reference value is set within other time periods, so that the finally-output actual volume is at a normal level, program watching is not influenced for the user, and intelligence is improved.

Further, if different time periods are switched during a process of playing a program watched by the user, for example, a rest period namely a specific time period is entered in a program playing process or the specific time period is exited, the audio amplitude reference value of the current time is updated in real time according to the time period corresponding to the current time and the mapping relationship, preset by the user, between different time periods and the corresponding audio amplitude reference values. Thus, the audio amplitude reference value of the current time can be updated in real time when different time periods are switched. For example, when a specific time period is switched to other time periods, the specific audio amplitude reference value is updated to a normal audio amplitude reference value in time, so the output volume is recovered to a normal volume, thereby avoiding influence on program watching of the user due to over-low output volume. When other time periods are switched to a specific time period, the normal audio amplitude reference value is updated to the specific audio amplitude reference value in time, so the output volume is reduced, thereby avoiding disturbing the user due to over-high output volume. The user does not need to manually operate the remote controller to tune the volume, thereby implementing convenience and quickness.

It is important to note that step S40 in the present embodiment may be executed before any one of steps S30, S20 and S10, which is not limited here. Execution of step S40 before step S30 in Fig. 2 is illustrated.

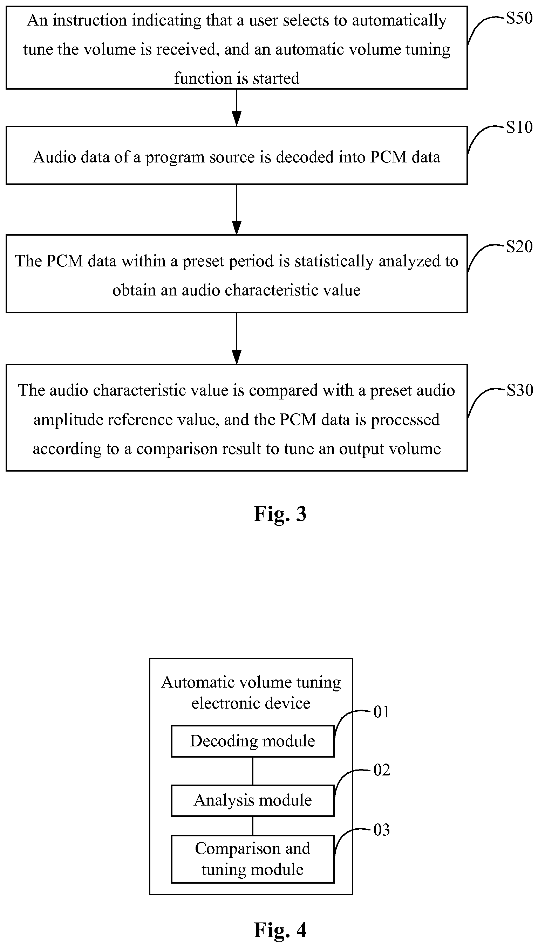

Fig. 3 is a flowchart of an automatic volume tuning method according to a third embodiment of the present disclosure.

As shown in Fig. 3, in the third embodiment, before step S10, the method further includes the following step S50.

At step S50, an instruction indicating that a user selects to automatically tune the volume is received, and an automatic volume tuning function is started.

The present embodiment further includes the operations of receiving an instruction indicating that a user selects to automatically tune the volume and starting an automatic volume tuning function. During practical use, the automatic volume tuning function may need to be started e.g., on a page. When it is unnecessary to use the automatic volume tuning function, the automatic volume tuning function is closed on the page. Thus, in the present embodiment, the automatic volume tuning function may be started or closed according to the requirements of the user. The user closes the automatic volume tuning function in an occasion where the automatic volume tuning function does not need to be used such as a high-volume occasion of Karaok and ball games, and enters a general volume processing mode. The user may manually tune the volume according to his/her own requirements, flexibility is improved, and convenience is further provided for the user.

It is important to note that step S50 in the present embodiment may be applied to the basis of the first embodiment or the second embodiment, which is not limited here. Application of step 50 to the basis of the first embodiment in Fig. 3 is illustrated.

Some embodiments of the present disclosure also provide a computer program, which includes program instructions. When the program instructions are executed by a computer, the computer is caused to execute any of the above-mentioned automatic volume tuning methods.

The embodiments of the present disclosure also provide a carrier carrying the computer program.

Some embodiments of the present disclosure further provide an automatic volume tuning electronic device.

It is important to note that in the embodiments of the present disclosure, the electronic device may be an electronic device having a playing function such as a television, a computer and a mobile terminal, or may be a processing device such as a digital set-top box and a network set-top box.

Fig. 4 is a functional module diagram of an automatic volume tuning electronic device according to a first embodiment of the present disclosure.

As shown in Fig. 4, in the first embodiment, the electronic device includes a decoding module 01, an analysis module 02 and a comparison and tuning module 03.

The decoding module 01 is arranged to decode audio data of a program source into PCM data.

In the present embodiment, the program source may be an audio/video program, or may be a pure audio program or other multimedia programs including audio data, which will not be limited here. After the program source is received, the audio data of the program source is decoded to obtain PCM data.

The analysis module 02 is arranged to statistically analyze the PCM data within a preset period to obtain an audio characteristic value.

The decoded PCM data is processed. Specifically, the PCM data within the preset period namely a certain time window is statistically analyzed to obtain an audio characteristic value capable of reflecting audio characteristics of the audio data of the program source. The audio characteristic value capable of reflecting the audio characteristic of the PCM data within the certain time window may include parameters such as a maximum amplitude, a minimum amplitude and an average audio amplitude value. The audio characteristic value may be obtained accurately by mathematical operation and combination of various parameters. In the present embodiment, the audio characteristic value is an average audio amplitude value of the PCM data with a preset period preferably, so as to avoid influence from over high amplitude and over low amplitude suddenly caused by interference within the preset period. The overall audio characteristics of the audio data of the program source can be reflected by the audio characteristic value. Certainly, the audio characteristic value is not limited as other parameter values.

The comparison and tuning module 03 is arranged to compare the audio characteristic value with a preset audio amplitude reference value, and process the PCM data according to a comparison result to tune an output volume.

In the present embodiment, a user may preset a common audio amplitude parameter value according to his/her own demands. When an audio is at the common audio amplitude parameter value, the output volume is optimal. The audio characteristic value namely an average audio amplitude value of the PCM data within the preset period is compared with a preset audio amplitude reference value. When the average audio amplitude value is greater than the preset audio amplitude reference value, the PCM data is attenuated until the average audio amplitude value is equal to the preset audio amplitude reference value. When the average audio amplitude value is smaller than the preset audio amplitude reference value, the PCM data is enhanced until the average audio amplitude value is equal to the preset audio amplitude reference value. In this way, the average audio amplitude value of the output PCM data is equal to the preset audio amplitude reference value. No matter whether original volumes of different program sources are the same, it can be ensured that the finally-output volume is optimal, thereby avoiding the situation of fluctuation of the output volume.

Further, in another implementation mode, the user may preset a common audio amplitude reference value and threshold values according to actual situations. The output volume is neither over-high nor over-low when the audio is within a range of upper and lower threshold values of the common audio amplitude reference value, so that the user can watch a program comfortably. Moreover, the output volume is limited within a small fluctuation range, so that the actual operation can be simple and quick.

The audio characteristic value capable of reflecting the audio characteristics of the audio data of the program source, namely an average audio amplitude value of the PCM data within the preset period, is compared with a preset audio amplitude reference value. When the average audio amplitude value is greater than the preset audio amplitude reference value and an absolute value of difference between the average audio amplitude value and the audio amplitude reference value is greater than a set threshold value, it represents that the average audio amplitude value excessively deviates from the audio amplitude reference value, the PCM data is entirely attenuated until the absolute value of the difference between the average audio amplitude value and the audio amplitude reference value is decreased below the set threshold value, thereby ensuring that the average audio amplitude value falls within a normal fluctuation range of the audio amplitude reference value. When the average audio amplitude value is smaller than the preset audio amplitude reference value and an absolute value of difference between the average audio amplitude value and the audio amplitude reference value is greater than a set threshold value, it represents that the average audio amplitude value excessively deviates from the audio amplitude reference value, the PCM data is entirely enhanced until the absolute value of the difference between the average audio amplitude value and the audio amplitude reference value is decreased below the set threshold value. Thus, by attenuating or enhancing the PCM data, the average audio amplitude value of the output PCM data is within the upper and lower threshold value range of the preset audio amplitude reference value. No matter whether the original volumes of different program sources are the same, it can be ensured that the finally-output volume is within a smaller fluctuation range, so the user can watch a program comfortably, thereby avoiding the situation of fluctuation of the output volume.

According to the present embodiment, audio data of a program source is decoded into PCM data, and an audio characteristic value capable of reflecting audio characteristics of the audio data is obtained. The audio characteristic value is compared with a preset normal audio amplitude reference value, and the PCM data is processed according to a comparison result to tune an output volume within a normal range. In this way, original volumes of different program sources can be tuned correspondingly to keep an actual output volume within a normal and stable range and avoid fluctuation of the output volume. The program watching comfort of the user is improved, the user does not need to manually operate a remote controller, the volume can be automatically tuned, and intelligence is improved.

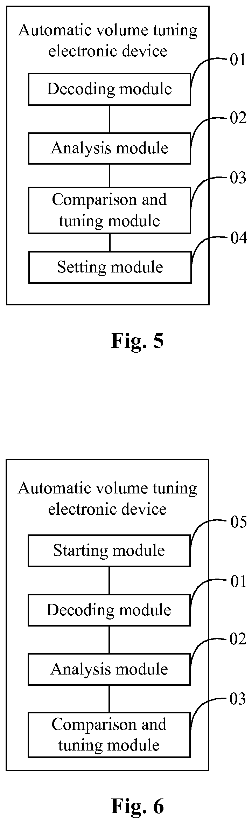

Fig. 5 is a functional module diagram of an automatic volume tuning electronic device according to a second embodiment of the present disclosure.

As shown in Fig. 5, in the second embodiment, the electronic device includes:
a setting module 04, arranged to obtain current time, and set an audio amplitude reference value of the current time according to a mapping relationship, preset by a user, between different time periods and audio amplitude reference values, as well as a time period corresponding to the current time.

In the present embodiment, the user may preset a mapping relationship between different time periods and corresponding audio amplitude reference values according to own requirements. That is, the user may set different audio amplitude reference values corresponding to different time periods. For example, the user may set time periods from 13:00 to 14:00 and from 22:00 to 8:00 as rest periods. A specific audio amplitude reference value which is relatively low is correspondingly set for a specific time period. Normal audio amplitude reference values are correspondingly set for other time periods, and the normal audio amplitude reference values may be relatively high.

Before the audio characteristic value is compared with the preset audio amplitude reference value and the PCM data is processed according to the comparison result, current time is obtained, and an audio amplitude reference value of the current time is set according to a time period corresponding to the current time and the mapping relationship, preset by the user, between different time periods and corresponding audio amplitude reference values. For example, in the present embodiment, if the current time is within time periods from 13:00 to 14:00 and from 22:00 to 8:00, the audio amplitude reference value of the current time is set as a specific audio amplitude reference value. If the current time is within other time periods, the audio amplitude reference value of the current time is set as a normal audio amplitude reference value. Thus, when the audio characteristic value is compared with the set audio amplitude reference value subsequently, different standard audio amplitude reference values can be set according to different time periods of the current time. A lower audio amplitude reference value is set within a rest period, so the finally-output actual volume is at a lower level, thereby avoiding disturbing the user. A normal audio amplitude reference value is set within other time periods, so the finally-output actual volume is at a normal level, program watching is not influenced for the user, and intelligence is improved.

Further, if different time periods are switched during a process of playing a program watched by the user, for example, a rest period namely a specific time period is entered in a program playing process or the specific time period is exited, the audio amplitude reference value of the current time is updated in real time according to the time period corresponding to the current time and the mapping relationship, preset by the user, between different time periods and the corresponding audio amplitude reference values. Thus, the audio amplitude reference value of the current time can be updated in real time when different time periods are switched. For example, when a specific time period is switched to other time periods, the specific audio amplitude reference value is updated to a normal audio amplitude reference value in time, so the output volume is recovered to a normal volume, thereby avoiding influence on program watching of the user due to over-low output volume. When other time periods are switched to a specific time period, the normal audio amplitude reference value is updated to the specific audio amplitude reference value in time, so the output volume is reduced, thereby avoiding disturbing the user due to over-high output volume. The user does not need to manually operate the remote controller to tune the volume, thereby implementing convenience and quickness.

Fig. 6 is a functional module diagram of an automatic volume tuning electronic device according to a third embodiment of the present disclosure.

As shown in Fig. 6, in the third embodiment, the electronic device includes:
a starting module 05, arranged to: receive an instruction indicating that a user selects to automatically tune the volume, and start an automatic volume tuning function.

The present embodiment further includes the operations of receiving an instruction indicating that a user selects to automatically tune the volume and starting an automatic volume tuning function. During practical use, the automatic volume tuning function needs to be started e.g., on a page. When it is unnecessary to use the automatic volume tuning function, the automatic volume tuning function is closed on the page. Thus, in the present embodiment, the automatic volume tuning function may be started or closed according to the requirements of the user, the user closes the automatic volume tuning function in an occasion where the automatic volume tuning function does not need to be used such as a high-volume occasion of Karaok and ball games, and enters a general volume processing mode, the user may manually tune the volume according to own requirements, flexibility is improved, and convenience is further provided for the user.

It is important to note that the starting module 05 in the present embodiment may be applied to the basis of the first embodiment or the second embodiment, which is not limited here. Application of the starting module 05 to the basis of the first embodiment in Fig. 6 is illustrated.

The sequence numbers of the embodiments of the present disclosure are merely used for descriptions and do not represent the strengths or weaknesses of the embodiments. By describing the above implementation mode, those skilled in the art may clearly know that the embodiment methods may be implemented by means of software and a necessary general hardware platform, or may, certainly, be implemented by hardware. However, under many circumstances, the former is a preferred implementation mode. Based on this understanding, the technical solutions of the present disclosure may be substantially embodied in a form of a software product or parts contributing to the related art may be embodied in a form of a software product, and a computer software product is stored in a storage medium (for example, a Read-Only Memory/Random Access Memory (ROM/RAM), a magnetic disk or an optical disc), which includes a plurality of instructions enabling a terminal device (a mobile phone, a computer, a server or a network device) to execute the method according to each embodiment of the present disclosure.

The above is only the exemplary embodiments of the present disclosure and is not thus limitative of the patent scope of the present disclosure. Equivalent structure or equivalent flow transformations made using the description and drawings of the present disclosure or direct or indirect applications to other relevant technical fields may fall within the patent protection scope of the present disclosure.

### Industrial Applicability

According to the automatic volume tuning method and electronic device in the technical solution provided by the embodiments of the present disclosure, audio data of a program source is decoded into PCM data, and an audio characteristic value capable of reflecting audio characteristics of the audio data is obtained; and the audio characteristic value is compared with a preset normal audio amplitude reference value, and the PCM data is processed according to a comparison result to tune an output volume within a normal range. In this way, original volumes of different program sources can be tuned correspondingly to keep an actual output volume within a normal and stable range and avoid fluctuation of the output volume. Therefore, the technical solution provided by the embodiments of the present disclosure has strong industrial applicability.

## Claims

1. An automatic volume tuning method, comprising:
decoding audio data of a program source into Pulse Code Modulation (PCM) data;
statistically analyzing the PCM data within a preset period to obtain an audio characteristic value; and
comparing the audio characteristic value with a preset audio amplitude reference value, and processing the PCM data according to a comparison result to tune an output volume.

2. The automatic volume tuning method as claimed in claim 1, wherein the audio characteristic value is an average audio amplitude value of the PCM data within the preset period.

3. The automatic volume tuning method as claimed in claim 2, wherein comparing the audio characteristic value with the preset audio amplitude reference value and processing the PCM data according to the comparison result to tune the output volume comprises:
when the average audio amplitude value is greater than the preset audio amplitude reference value and an absolute value of difference between the average audio amplitude value and the audio amplitude reference value is greater than a set threshold value, attenuating the PCM data until the absolute value of the difference between the average audio amplitude value and the audio amplitude reference value is decreased below the set threshold value;
when the average audio amplitude value is smaller than the preset audio amplitude reference value and an absolute value of difference between the average audio amplitude value and the audio amplitude reference value is greater than a set threshold value, enhancing the PCM data until the absolute value of the difference between the average audio amplitude value and the audio amplitude reference value is decreased below the set threshold value.

4. The automatic volume tuning method as claimed in claim 1, wherein before comparing the audio characteristic value with the preset audio amplitude reference value and processing the PCM data according to the comparison result to tune the output volume, the method further comprises:
obtaining current time, and setting an audio amplitude reference value of the current time according to a mapping relationship, preset by a user, between different time periods and audio amplitude reference values, as well as a time period corresponding to the current time.

5. The automatic volume tuning method as claimed in claim 4, wherein after setting the audio amplitude reference value of the current time according to the mapping relationship, preset by the user, between different time periods and audio amplitude reference values as well as the time period corresponding to the current time, the method further comprises:
when a current time period switches to a different time period in a program playing process, updating the audio amplitude reference value of the current time in real time according to the mapping relationship, preset by the user, between different time periods and the audio amplitude reference values as well as the time period corresponding to the current time.

6. The automatic volume tuning method as claimed in any one of claims 1-5, wherein before decoding the audio data of the program source into the PCM data, the method further comprises:
receiving an instruction indicating that a user selects to automatically tune the volume, and starting an automatic volume tuning function.

7. An automatic volume tuning electronic device, comprising a decoding module, an analysis module and a comparison and tuning module, wherein
the decoding module is arranged to decode audio data of a program source into Pulse Code Modulation (PCM) data;
the analysis module is arranged to statistically analyze the PCM data within a preset period to obtain an audio characteristic value; and
the comparison and tuning module is arranged to compare the audio characteristic value with a preset audio amplitude reference value, and process the PCM data according to a comparison result to tune an output volume.

8. The electronic device as claimed in claim 7, wherein the audio characteristic value is an average audio amplitude value of the PCM data within the preset period.

9. The electronic device as claimed in claim 8, wherein the comparison and tuning module is arranged to compare the audio characteristic value with the preset audio amplitude reference value and process the PCM data according to the comparison result to tune the output volume according to the following mode:
when the average audio amplitude value is greater than the preset audio amplitude reference value and an absolute value of difference between the average audio amplitude value and the audio amplitude reference value is greater than a set threshold value, attenuating the PCM data until the absolute value of the difference between the average audio amplitude value and the audio amplitude reference value is decreased below the set threshold value;
when the average audio amplitude value is smaller than the preset audio amplitude reference value and an absolute value of difference between the average audio amplitude value and the audio amplitude reference value is greater than a set threshold value, enhancing the PCM data until the absolute value of the difference between the average audio amplitude value and the audio amplitude reference value is decreased below the set threshold value.

10. The electronic device as claimed in claim 7, further comprising a setting module, wherein
the setting module is arranged to obtain current time, and set an audio amplitude reference value of the current time according to a mapping relationship, preset by a user, between different time periods and audio amplitude reference values, as well as a time period corresponding to the current time.

11. The electronic device as claimed in claim 10, wherein the setting module is further arranged to:
update, when a current time period switches to a different time period in a program playing process, the audio amplitude reference value of the current time in real time according to the mapping relationship, preset by the user, between different time periods and the audio amplitude reference values as well as the time period corresponding to the current time.

12. The electronic device as claimed in any one of claims 7-11, further comprising a starting module, wherein
the starting module is arranged to receive an instruction indicating that a user selects to automatically tune the volume, and start an automatic volume tuning function.

13. A computer program, comprising program instructions, wherein when the program instructions are executed by a computer, the computer is caused to execute the automatic volume tuning method as claimed in any one of claims 1-6.

14. A carrier, carrying the computer program as claimed in claim 13.
